# EUROPEAN PATENT APPLICATION

(11) **EP 4 753 439 A1**
(43) Date of publication of application: **03.06.2026**
(21) Application number: 25219521.9
(22) Date of filing: 28.11.2025
(51) Int. Cl.: H10W 70/40, H10W 72/00, H10W 72/60, H10W 74/00

(54) **A SEMICONDUCTOR PACKAGE AND A BOND CLIP FOR USE IN THE SEMICONDUCTOR PACKAGE**

(30) Priority: 30.11.2024 NL 2039211
(71) Applicant: Nexperia B.V., 6534 AB Nijmegen (NL)
(72) Inventor: Ng, To Kam, Hong Kong (HK); Ho, Wai Keung, Hong Kong (HK); Shiu, Hei Ming, Hong Kong (HK)
(74) Representative: Pjanovic, Ilija

(57) **Abstract**

The present disclosure provides a semiconductor package comprising: a semiconductor die attached to a lead frame having lead terminals; at least one bond clip connecting the die to a lead terminal; a die top solder connecting the bond clip and the die, and an encapsulant. The clip comprises a die attachment portion having a die attachment portion side structured to be connected to the die, whereby said side is provided with a cavity functioning as an expansion space for the die top solder. This allows to prevent the molten die top solder from spreading toward die edge and lead terminals, since the molten solder flow is directed inward to the cavity, instead of flowing outward. A bond clip for use in a semiconductor package is also provided, comprising a cavity functioning as an expansion space for the die top solder. The cavity is arranged at the die attachment portion side of the bond clip.

## Description

### TECHNICAL FIELD

The present disclosure relates to conductive clip technology in semiconductor packaging, and more particularly, to a semiconductor assembly having conductive bond clips for connecting the semiconductor die to the die terminations within a package.

### BACKGROUND OF THE DISCLOSURE

Semiconductor assemblies, such as transistors, are manufactured as layered assemblies including components such as lead frame with semiconductor dies and leads encapsulated with epoxy moulding compound. Typical semiconductor devices comprise a semiconductor die attached to a lead frame and are encapsulated to form a packaged semiconductor device. A lead frame is a metal frame made of metal such as copper or its alloys that holds the die on its die pad and provides the conductive path between the die and external circuits. The typical semiconductor assembly, also referred to as semiconductor package, usually comprises bonding pads electrically connected to the lead terminals of the lead frame with bond wires, whereby the bond wires are thin wires, often made of gold, copper or aluminium. Leads are metal pins that extend from the semiconductor die to the exterior of the package for connection to a printed circuit board (PCB).

Power electronics involve applying high voltages to their terminals and handling significant amounts of current flow, which can be constrained by the electrical resistance and thermal impedance of the package. The conventional wire-bonding approach often requires a large number of source wires to minimize conduction losses or enhance power density, primarily due to the drain-source on resistance - RDS(on). The wires are exceedingly long and thin and have parasitic inductance, especially at high frequency that can affect both speed of operation and efficiency. Moreover, large number of source wires reduces manufacturing productivity and increases material cost.

As an alternative to traditional wire bonding, for connecting the semiconductor silicon die to the package lead terminals, electrically conductive bond clips are used, such as copper clips. Conductive clips, also referred to as bond clips, are an essential component in modern semiconductor packaging and improve the performance and reliability of electronic devices.

This packaging technology is widely employed in power devices such as diodes, MOSFETs, and IGBTs (Insulated Gate Bipolar Transistors). Conductive bond clips offer many benefits, one of the most important of which is reducing the overall package resistance of the product when compared to connections made with wires. Bond clips create an electrical and thermal path between the lead terminals, die, and substrate within the power module structure to improve thermal management within the device. Therefore, conductive clip technology is becoming the preferred interconnect.

RDS(on) losses result in temperature rises in the device and the semiconductor device may be damaged or destroyed by excessive temperature. Conductive clip contact areas are much larger than with wire bonding. This increase in area results in better thermal performance by providing efficient heat dissipation from die top to the lead frame. It helps to reduce the maximum junction temperature during operation and extend the device's operation life and reliability. Moreover, high thermal conductivity of materials such as copper allows it to effectively dissipate heat from the semiconductor die. This capability is crucial for maintaining device reliability and performance under high power and temperature conditions. When a conductiveclip package is combined with a heat sink, more heat can be transferred to the air through natural convection or forced air cooling. Depending on the size of the heat sink used on the top-side of the package and any air flow that may be present, the thermal resistance can be further improved as it allows the package to run cooler or draw more power while maintaining a stable junction temperature. Conductive bond clips can handle higher current densities than traditional bonding wires, making them suitable for applications requiring high current flow without significant increases in size or complexity. Copper, widely used for manufacturing bond clips, has also excellent electrical conductivity, which reduces the resistance and inductance associated with current flow. Compared to wire bonds, conductive clips, e.g. copper clips, can provide a more robust and uniform current path, resulting in lower power losses and improved efficiency in high-power applications. Moreover, such clips offer stronger physical connections between the die and the package compared to wire bonds and add mechanical stability to the die and thus help protect against potential damage from mechanical stresses. This enhances the package's durability and can reduce mechanical stress, leading to better reliability in harsh operating conditions.

The semiconductor packaging may utilize more than one bond clip, for example it may be a dual clip package or multiple clip package. Dual clip packages utilize two clips to create multiple electrical connections within the same package. Dual clip structures minimize parasitic inductance by offering a direct and parallel connection path between different sections of the package. This leads to better overall performance in fast-switching applications. These packages are particularly beneficial for power management devices, such as half-bridge MOSFETs and other multi-die arrangements.

Overall, conductive clips in semiconductor packages have become a preferred solution for high-power and high-performance applications due to their superior electrical, thermal, and mechanical properties compared to traditional wire bonding methods.

In clip-bonding technology a solid conductive bridge is attached to the die surface, replacing multiple bonded wires. The clip directly connects the semiconductor die to the lead terminals. The solder joint serves as the medium that attaches the conductive clip to the die and lead terminals or other connection points, forming a strong bond that secures the clip in place and allowing direct contact between the clip and the die, thereby minimizing contact resistance, ensuring effective electrical conductivity and providing mechanical stability. The solder joint aids in creating a continuous thermal path from the die through the clip, ensuring efficient heat transfer.

During assembly process, solder paste or pre-formed solder is applied between the clip and the die as well as between the clip and the lead terminals. Then, the entire assembly undergoes a reflow soldering process where the solder melts and solidifies to form a permanent bond, creating a reliable electrical and thermal connection.

Soft solder is commonly used in clip bonded packages to enhance product thermal and electrical performance. The solder joint experiences repeated heating and cooling cycles due to the operation of power electronics, which causes thermal expansion and contraction of materials at different rates. This cyclic stress within the solder joint may result in the formation of microcracks or progressive delamination within the joint, eventually compromising the mechanical and electrical integrity of the connection. Prolonged exposure to high temperatures may also cause the solder material to slowly deform under the stress, leading to a weakened bond.

Typically, high lead (Pb) soft solders with melting point of 290oC to 310oC are used. In high surge current application (or IFSM, Instantaneous Forward Surge Current), a large amount of heat is generated, and thus in-flow electrical current heats up solder joint above its melting temperature. This causes the soft solder inside package to melt. While solder melts, its volume expands. From solid state solder to liquid state solder, there occurs solder volume expansion. The solder volume expansion exerts pressure on package interface between epoxy moulding compound (EMC) and the surface of the die, leading to package delamination or cracking. Molten solder spreads along this delamination gap to die edges and termination (leads), causing electrical failures of the semiconductor device.

There is a need to address the disadvantages of existing conductive clip bond semiconductor assemblies, associated with solder volume increase and melting after high surge application, resulting in solder spread to the silicon die edge, which causes electrical failures.

### SUMMARY OF THE DISCLOSURE

The failures of the semiconductor devices associated with solder melting after high surge application adversely impact the performance, reliability, and lifespan of electronic devices. To mitigate these risks, a novel conductive bond clip design is provided, allowing to manage thermal and mechanical stresses of the solder joint. The design of the clip provides buffer space under copper clip which functions as reservoir for the solder volume expansion during remelt by high surge current.

Accordingly, the present disclosure provides a conductive clip bond package having solder joint as interconnection media between the semiconductor die and the conductive clip, having improved surge current performance. More precisely, the present invention allows to eliminate solder spread due to volume increase and melting of the solder, and thus eliminate bridging to die terminations.

According to the first aspect, a semiconductor package is provided, comprising:
a semiconductor die having a first die side and a second die side opposite to the first die side;
a lead frame having lead terminals, a first frame side and a second frame side opposite to the first frame side, wherein the semiconductor die is attached with its first die side to the second frame side of the lead frame;
at least one bond clip electrically and mechanically connecting the second die side of the semiconductor die to at least one of the lead terminals;
a die top solder connecting the bond clip and the semiconductor die, and
an electrically insulating encapsulant at least partly encapsulating the lead frame, the semiconductor die, the at least one bond clip and the lead terminals.

The bond clip at least comprises a die attachment portion having a die attachment portion side structured to be connected to the second die side of the semiconductor die, and a lead terminal attachment portion structured to be connected to the lead terminal of the lead frame.

The die attachment portion side of the die attachment portion is provided with a cavity functioning as an expansion space for the die top solder. This allows to prevent the molten die top solder from spreading toward die edge and lead terminals, since the molten solder flow is directed inward to the cavity serving as the expansion space, instead of flowing outward toward the die edge and lead terminals. Therefore, solder spread and bridging to die edge and lead terminations is avoided, and thus the performance of the semiconductor package is greatly improved.

Preferably, the cavity is separated from the die top solder by a solder non-wettable substance. This allows to prevent wetting of the surface of the cavity by solder during reflow soldering process, where the solder melts and solidifies to form a permanent bond. Since the die attachment portion side is separated from the die top solder by a layer of solder non-wettable substance, the cavity remains empty after reflow, creating an air space serving as expansion space, since the solder cannot wet on the surface of the cavity.

Preferably, the solder non-wettable substance is applied on the surface of the cavity. This allows for convenient application of the solder non-wettable substance, since the edges of the cavity are clearly visible.

Alternatively, the solder non-wettable substance is applied on the surface of die top solder facing the die attachment portion side. This allows for example for employing a manufacturing process flow in which the bond clip is applied on the die top solder already having a layer of solder non-wettable substance.

Preferably, the solder non-wettable substance is a thin organic coating or a Cu oxide layer, however any other solder non-wettable substance may be applied.

When the solder melts, its volume expands by approximately 6% to 8%. Therefore, to encompass significant amount of the molten solder, the cavity preferably has a volume corresponding to at least 6% of the overall volume of the die top solder.

Preferably, the cavity occupies a surface area of 1% to 10% of the surface area of the die attachment portion side of the die attachment portion, to ensure even distribution of the molten solder in the cavity.

Preferably, the bond clip comprises copper. Copper has good electrical conductivity, which reduces the resistance and inductance associated with current flow.

Preferably, the cavity is formed as at least one groove.

For example, the cavity may be formed as a plurality of parallel grooves.

For example, the grooves may be arranged obliquely or parallelly to a side edge of the die attachment portion of the bond clip.

In another example, the cavity may have a form of intersecting grooves.

The intersecting grooves may for example intersect at their centers or may be arranged in a grid, forming a matrix of protrusions.

In another example, the cavity may have a form of at least one circular groove, for example multiple concentric circular grooves.

In cross section, the at least one groove may V-shaped, U-shaped or rectangular shaped. This depends on the device used for manufacturing the cavity.

In another example, the cavity may have a form of blind holes, preferably circular, square, rectangular or triangular holes. The holes may be arranged in rows to form a matrix of holes.

In obvious manner, the semiconductor package may be a multiple semiconductor package having more than one bond clip, such as example dual-clip semiconductor package.

According to the second aspect of the disclosure, a bond clip for use in a semiconductor package is provided, the bond clip at least comprising:
a die attachment portion having a die attachment portion side structured to be connected to a semiconductor die of the semiconductor package;
and a lead terminal attachment portion structured to be connected to a lead terminal of a lead frame of the semiconductor package;
wherein the die attachment portion side of the die attachment portion is provided with a cavity functioning as an expansion space for a die top solder.

The cavity allows to prevent the molten die top solder from spreading toward die edge and lead terminals, since the molten solder flow is directed inward to the cavity serving as the expansion space, instead of flowing outward toward the die edge and lead terminals. Therefore, solder spread and bridging to die terminations is avoided, and thus the performance of the semiconductor package is greatly improved.

Preferably, the solder non-wettable substance is applied on the surface of the cavity. This allows for convenient application of the solder non-wettable substance, since the edges of the cavity are clearly visible.

Preferably, the solder non-wettable substance is a thin organic coating or a Cu oxide layer, however any other solder non-wettable substance may be applied.

Preferably, the bond clip comprises copper. Copper has good electrical conductivity, which reduces the resistance and inductance associated with current flow.

Preferably, the cavity is formed as at least one groove.

For example, the cavity may be formed as a plurality of parallel grooves.

For example, the grooves may be arranged obliquely or parallelly to a side edge of the die attachment portion of the bond clip.

In another example, the cavity may have a form of intersecting grooves.

The intersecting grooves may for example intersect at their centers or may be arranged in a grid, forming a matrix of protrusions.

In another example, the cavity may have a form of at least one circular groove, for example multiple concentric circular grooves.

In cross section, the at least one groove may V-shaped, U-shaped or rectangular shaped. This depends on the device used for manufacturing the cavity.

In another example, the cavity may have a form of blind holes, preferably circular, square, rectangular or triangular holes. The holes may be arranged in rows to form a matrix of holes.

The optional and/or preferred features of each aspect of the disclosure as set out herein are also applicable to any other aspects of the disclosure where appropriate.

### BRIEF DESCRIPTION OF THE DRAWINGS

The disclosure of the present invention will now be discussed, by way of example only, with reference to the accompanying drawings in which:
Figure 1 shows a semiconductor package in an assembled state in a perspective view;
Figure 2 shows a semiconductor package in an exploded view;
Figure 3A shows the semiconductor package in top view,
Figure 3B shows the semiconductor package in side view
Figure 3C shows the semiconductor package in front view;
Figure 4 shows the semiconductor package in an assembled state, without the encapsulant, and the attachment process of the bond clip to the semiconductor die, where the cavity is in the form of intersecting grooves;
Figure 5 shows the semiconductor package in an assembled state, without the encapsulant, and the attachment process of the bond clip to the semiconductor die, where the cavity is in the form of concentric circles;
Figures 6A-6B show the bottom surface of the bond clip having the solder non-wettable layer applied on the cavity;
Figure 7 shows examples of the shapes of the cavity at the bottom surface of the bond clip, where:
   Fig. 7A shows the cavity in the form of grooves intersecting at their centers,
   Fig. 7B shows the cavity in the form of concentric circles,
   Fig. 7C shows the cavity in the form of matrix of blind holes,
   Fig. 7D shows the cavity in a form of parallel grooves arranged obliquely to the edge of the clip attachment part,
   Fig. 7E shows the cavity in a form of parallel grooves arranged obliquely to the edge of the clip attachment part, oppositely to the arrangement shown in Fig. 7D,
   Fig. 7F shows the cavity in a form of parallel grooves arranged parallelly to the edge of the clip attachment part,
   Fig. 7G shows the cavity in a form of parallel grooves arranged parallelly to another edge of the clip attachment part than in Fig. 7F,
   Fig. 7H shows the cavity in a form of a grid of grooves intersecting at right angles, forming a matrix of upward dimples, where the grooves are parallel to the edge of the clip attachment part,
   Fig. 7I shows the cavity in a form of a grid of grooves intersecting at right angles, forming a matrix of upward dimples, where the grooves are oblique to the edge of the clip attachment part;
Fig. 8 shows a dual-clip semiconductor assembly in an assembled state in a perspective view;
Figure 9A shows the dual-clip semiconductor assembly in top view;
Figure 9B shows the dual-clip semiconductor assembly in side view;
Figure 9C shows the dual-clip semiconductor assembly in front view.

### DETAILED DESCRIPTION OF THE DISCLOSURE

According to one aspect of the present disclosure, there is provided a semiconductor package comprising a bond clip having a cavity functioning as an expansion space for the melted solder. According to another aspect of the present disclosure, there is provided a bond clip having a cavity functioning as expansion space for the melted solder.

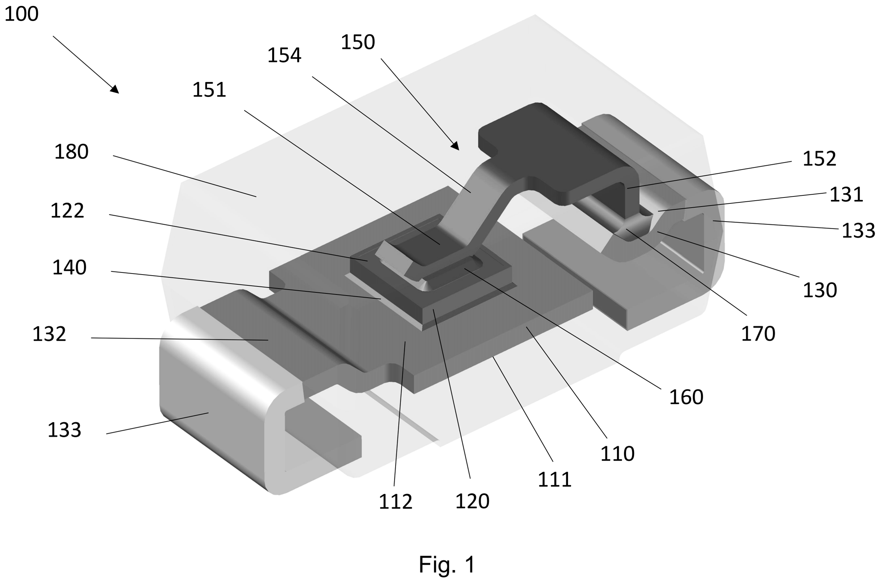

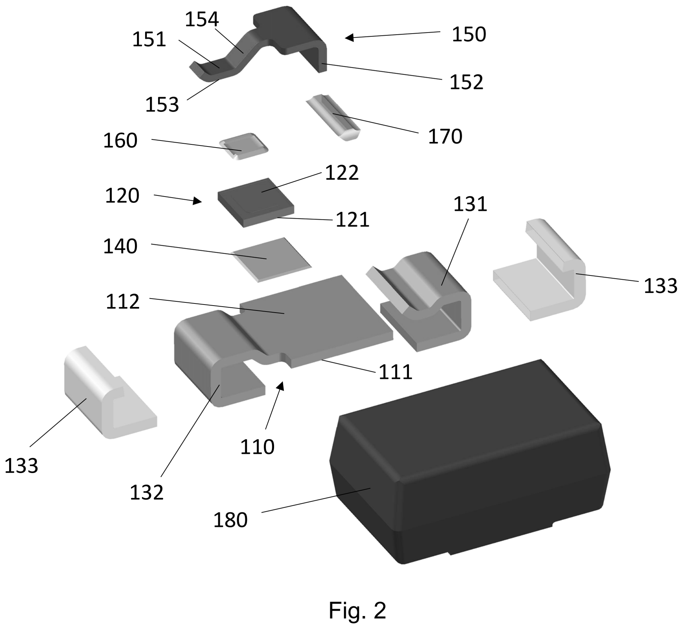

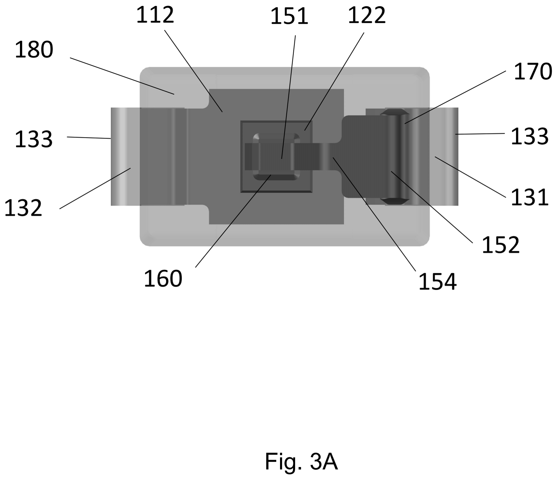

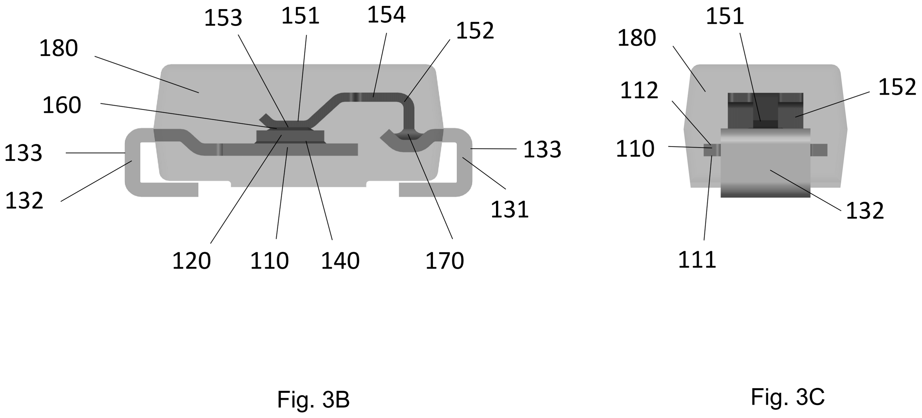

Figure 1 depicts a semiconductor package 100 in an assembled state in a perspective view. Figure 2 depicts the semiconductor package 100 in an exploded view. Figures 3A, 3B and 3C show the semiconductor package 100 in top view, side view and front view, respectively. As shown in Figures 1 to 3, the semiconductor package 100 comprises a lead frame 110 having a first frame side 111 and a second frame side 112 opposite to said first frame side 111, whereby the lead frame 110 is a metal frame made of metal such as copper or its alloys. A semiconductor die 120 is attached to this lead frame 110, more specifically to the second frame side 112 of the lead frame 110. More specifically, a part of the lead frame 110 where the semiconductor die 120 is physically mounted may be referred to as die pad. The semiconductor die 120 has a first die side 121 and a second die side 122 opposite to said first die side 121, whereby the first die side 121 faces the second frame side 112 of the lead frame 110. The first die side 121 of the die 120 is thus coupled to the second frame side 112 of the lead frame 110.

The lead frame 110 holds the die 120 and provides the conductive path between the die 120 and external circuits. The semiconductor package 100 further comprises lead terminals 131,132, i.e. first lead terminal 131 and second lead terminal 132, (also referred to as leads) of the lead frame 110 (extending from the lead frame 110 substantially parallelly to said lead frame 110, i.e. from its edges), the lead terminals 131,132 being metal conductors leading away from the die 120 to the exterior of the semiconductor package 100 for connection to a printed circuit board (PCB) and/or to other electrical components. The lead terminals 131,132 may be tin plated, and thus may have a layer of tin plating 133, as shown in Fig. 1 and Fig. 2. Before singulation, the leads and the lead frames of adjacent packages are connected to each other. After singulation, the leads may be bent or shaped in various configurations to facilitate mounting on a PCB, and serve as electrical connection between the die and the external circuits. The first lead terminal 131 is spaced apart from the die pad of the lead frame 110, while the second lead terminal 132 is extending from the die pad of the lead frame 110 and connected to it.

The first die side 121 of the semiconductor die 120 may be connected to the second frame side 112 of the lead frame 110 for example by solder joint, i.e. by die bottom solder 140.

The semiconductor die 120 is connected to the electrically conductive bond clip 150, the bond clip 150 being coupled to the second die side 122 of the die 120. The bond clip 150 is formed of a shaped strip of electrically conductive material, and it electrically and mechanically connects the second die side 122 of the semiconductor die 120 to at least one lead terminal, i.e. first lead terminal 131. As shown, the lead terminal 131 is spaced apart from the lead frame 110. The bond clip 150 is a structure made of conductive material, for example of copper or of a material containing copper. The bond clip 150 thus electrically connects semiconductor die 120 to the package lead frame 110, and to the package I/O lead terminal 131.

The bond clip 150 has a die attachment portion 151 and a lead terminal attachment portion 152. The die attachment portion 151 of the bond clip 150 is intended to fixedly couple the bond clip 150 to the semiconductor die 120 in a desired physical arrangement. The die attachment portion 151 of the bond clip 150 has a die attachment portion side 153 structured to be connected to the semiconductor die 120, more precisely to the second die side 122 of the die 120.

The lead terminal attachment portion 152 of the bond clip 150 is intended to fixedly couple the clip 150 to the first lead terminal 131 in a desired physical arrangement. The lead terminal attachment portion 152 is thus structured to be connected to the (spaced apart) first lead terminal 131 of the lead frame 110.

The die attachment portion 151 and the lead terminal attachment portion 152 are connected for example by bridge portion 154 extending between the die attachment portion 151 and the lead terminal attachment portion 152.

As interconnection media between the semiconductor die 120 and the bond clip 150, a solder joint, i.e. the die top solder 160, is provided. More precisely, the die attachment portion side 153 of the die attachment portion 151 of the bond clip 150 faces the die top solder 160 and is coupled to the die 120 by said die top solder 160, whereby the die top solder 160 is arranged on the second die side 122 of the die 120.

The other end of the bond clip 150, i.e. lead terminal attachment portion 152, is connected to at least one first lead terminal 131 preferably by solder joint, i.e. by lead solder 170. The lead terminal attachment portion 152 may be vertically offset to couple with the first lead terminal 131.

The semiconductor package 100 is encapsulated with an electrically insulating encapsulant 180, typically made of plastic or epoxy resin. The encapsulant 180 at least partially encapsulates the lead frame 110, at least partially encapsulates the semiconductor die 120, at least partially encapsulates the bond clip 150 and at partially encapsulates the lead terminals 131, 132. The encapsulant 180 is presented in Fig. 1 and Fig. 3 transparently, to show the internal components of the package 100. The encapsulant 180 protects the semiconductor die 120 and other components forming part of the semiconductor package 100 from environmental and physical damage. The encapsulant 180 may otherwise be referred to as a mold body, EMC, casing or housing.

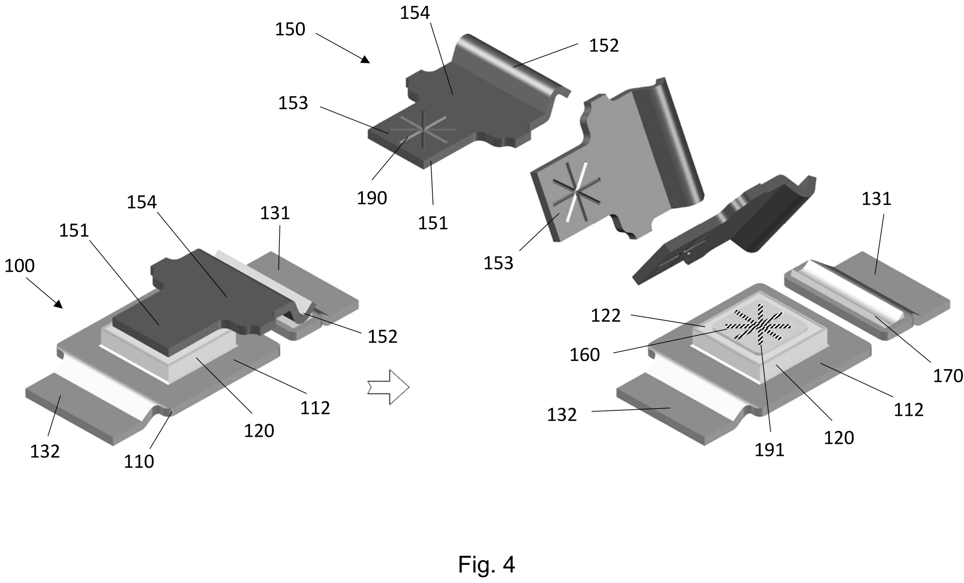

Figure 4 depicts a semiconductor package 100 in an assembled state, without an encapsulant 180 visible, whereby the bond clip 150 has a die attachment portion 151 of a different shape than shown in Figs. 1 to 3, i.e. being wider and having bigger surface with reference to the die 120, than shown in Figs. 1 to 3. The shape of the bond clip 150 does not affect the present disclosure and may depend on the particular needs, such as the size of the die 120.

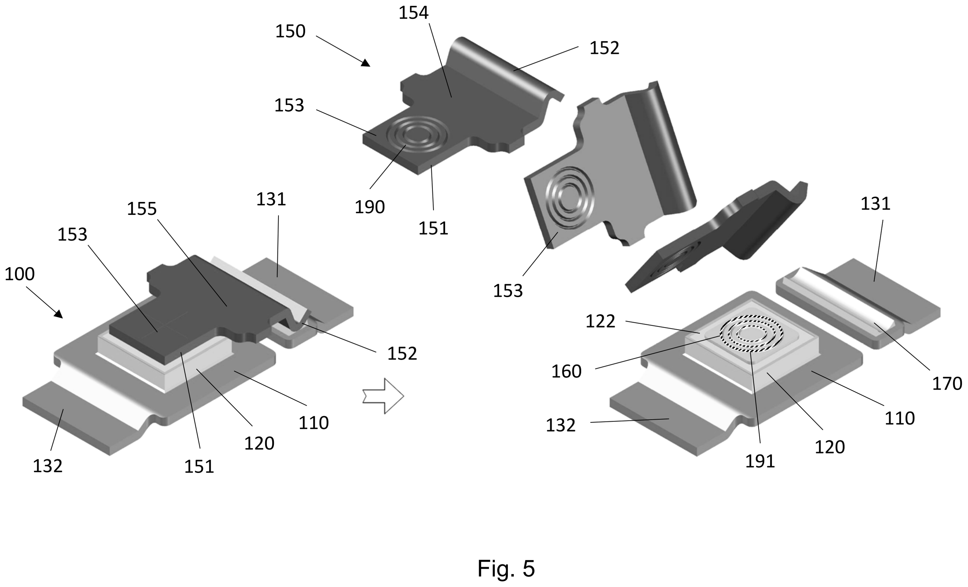

Figure 4 and Figure 5 show the bond clip 150 from the side of its die attachment portion side 153. Figure 4 and Figure 5 also show the attachment process flow of the bond clip 150 to the semiconductor die 120, to clearly depict which surface of the bond clip 150 faces the second die side 122 of the die 120 and how the bond clip 150 is positioned on the second die side of the semiconductor die 120. Between the second die side 122 of the die 120 and the die attachment portion side 153 of the bond clip 150, the die top solder 160 is provided. The die top solder 160 is applied on the second die side 122 of the die 120 or on the die attachment portion side 153 of the clip 150 using known methods, for example by applying solder paste or pre-formed solder on either of said surfaces.

Preferably, in the same manner the solder joint is also provided between the first lead terminal 131 and the lead terminal attachment portion 152 of the bond clip 150 to form lead solder 170, and between the first die side 121 of the die 120 and the second frame side 112 of the lead frame 110 to form die bottom solder 140.

After applying solder and assembling the package, i.e. after the conductive bond clip is positioned, the package undergoes a reflow soldering process where the solder melts and solidifies to form a permanent bond, creating a reliable electrical and thermal connection.

As mentioned above, typically, for providing solder joints, high lead (Pb) soft solders are used. High lead soft solders typically have melting point of 290oC to 310oC. The solder joint experiences repeated heating and cooling cycles during use of the semiconductor devices, which causes melting and thermal expansion of the solder. More specifically, in high surge current application, a large amount of heat is generated, heating up solder joint(s) above its melting temperature. This causes the solder inside the package to melt and expand as its volume increases. From solid state solder to liquid state solder, there occurs solder volume expansion of approximately 6% to 8%. The solder volume expansion exerts pressure on package interface between the encapsulant and the surface of the die, leading to package delamination and/or cracking. Molten solder spreads along this delamination gap to the die edge and lead terminals, causing electrical failures.

Therefore, to overcome said problem, there is provided a semiconductor package 100 comprising the bond clip 150 which has a cavity 190 provided at its die attachment portion side 153, facing the second die side 122 of the semiconductor die 120. This is shown in Figs. 4 to 7. The presence of the cavity 190 on the die attachment portion side 153 of the bond clip 150 causes that after package assembly, an empty space is provided between the die top solder 160 and die attachment portion side 153 of the clip 150. The cavity 190 serves as a buffer space or reservoir for expanded solder caused by melting due to high temperature. In other words, the buffer space in the form of the cavity 190 is provided to encompass excessive volume of the molten solder of the die top solder 160. Expansion space formed by cavity 190 provided under the bond clip 150 allows to relax the pressure generated by solder expansion and minimize thermal stress. This allows to prevent the molten die top solder 160 from spreading toward silicon die edge, since the molten solder flow is directed inward to said cavity 190 (expansion space) instead of flowing outward toward the die edge and lead terminals. Therefore, by eliminating solder spread and bridging to die terminations, the performance of the semiconductor package is greatly improved in high surge current applications.

The cavity 190 is provided on the die attachment portion side 153 of the clip 150 using any appropriate method, such as etching, stamping or laser engraving, or any other known method suitable for use with metal, especially copper.

To prevent wetting of the surface of the cavity 190 by solder during clip bonding and reflow soldering process, where the solder melts and solidifies to form a permanent bond, the die attachment portion side 153 is separated from the die top solder 160 by a layer of solder non-wettable substance 191. This allows the cavity 190 to remain empty after assembly process, creating an air space serving as expansion space, since the solder cannot wet on the surface of the cavity 190.

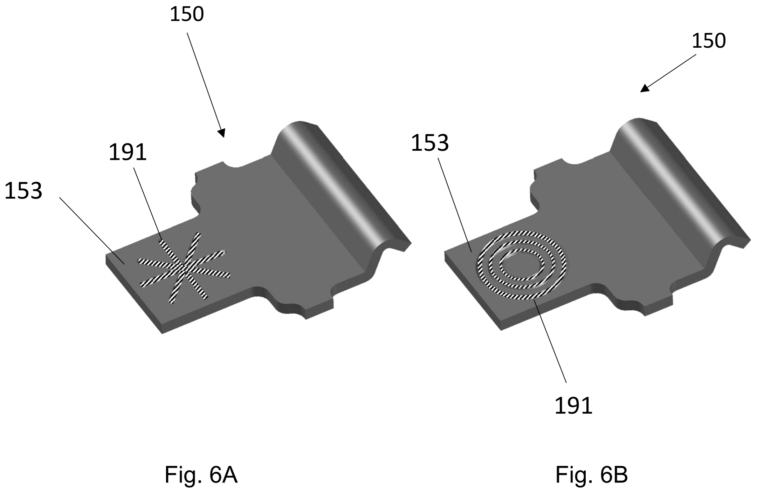

The thin layer of solder non-wettable substance 191, during manufacturing, may be applied on the surface of the cavity 190, as shown in Figs. 6A-6B (i.e. before attaching the clip 150 to the die top solder 160). Figs. 6A and 6B shows two exemplary shapes of the cavity 190 having the layer of solder non-wettable substance 191. This allows for convenient application of the layer of solder non-wettable substance 191, since the edges of the cavity 190 are clearly visible and thus the application is facilitated. Alternatively, the layer of solder non-wettable substance 191 may be applied on the surface of die top solder 160. This allows for example for employing a manufacturing process flow in which the bond clip 150 is applied on the die top solder 160 already having a layer of solder non-wettable substance 191. After assembly of the semiconductor package 100, the portion of the die top solder 160 surface coated with solder non-wettable substance 191 is located directly under the surface of the cavity 190, as shown in Fig. 4 and Fig. 5.

For example, the layer of solder non-wettable substance 191 may be a thin organic coating or a Cu oxide layer formed during laser engraving. Other possible materials which may be used as solder non-wettable substance 191 may be for example: parylene, silicone or another metal oxide layer. Preferably, the metal oxide layer is obtained by applying a layer of an easily oxidized metal, such as aluminum (which be converted to Al oxide). Solder non-wettable substance plating 191 may be made also by applying a thin film using atomic layer deposition (ALD) technique.

To encompass sufficient volume of expanded solder expanded, the cavity 190 has preferably a volume corresponding to at least 6% of the overall volume of the die top solder 160 under the clip 150. Most preferably, the volume of the entrapped space formed by the cavity 190 is from 6% to 8% of the overall solder volume of the die top solder 160.

Preferably, the cavity 190 occupies a surface area of 1% to 10% of the surface area of the die attachment portion side 153 of the clip attachment part 151. In other words, if the die attachment portion side 153 which comes into contact with the die top solder 160 is defined as 100%, then 1% to 10% of said die attachment portion side 153 should be occupied by the cavity 190, to allow proper flow of the solder into the cavity 190. This allows for even distribution of the molten solder in the cavity 190.

When the bond clip 150, and more precisely the attachment part 151 of the bond clip 150, has a thickness defined as 100%, the depth of the cavity 190 may be 30% of the thickness of the clip attachment part 151, preferably 30% to 70% of the thickness of the clip attachment part 151.

The shape and/or pattern of the cavity 190 may vary depending on, for example, size and shape of the semiconductor die 120. Thus, the cavity 190 may have any pattern, as long as it provides a hollow expansion space between the die attachment portion side 153 of the bond clip 150 and the die top solder 160, capable of embracing sufficient volume of melted solder. For example, it may have a form of at least one groove or at least one hole.

As shown in Fig. 4, the cavity 190 may have a form of intersecting grooves, i.e. four grooves intersecting at their centers, forming a shape resembling a star. In yet another examples (not shown), the number of intersecting grooves may be different or the point of intersect may be different than the centers of the grooves.

As shown in Fig. 5, the cavity 190 may have a form of circular grooves. For example, the circular grooves may be arranged as multiple circles arranged one inside the other, concentrically or non-concentrically, or arranged close to each other. In Fig. 5, three circular grooves are arranged concentrically. In yet another examples (not shown), the number of circles may be different or their arrangement may vary (for example, the circles may intersect). In cross section, the circles may be for example V-shaped, U-shaped, shaped rectangularly or may have any other irregular shape.

In another example, the grooves may be elliptical. In yet another example, the grooves may have other closed shape, such as square, triangle, star, kite, trapezium or any other irregular closed shape.

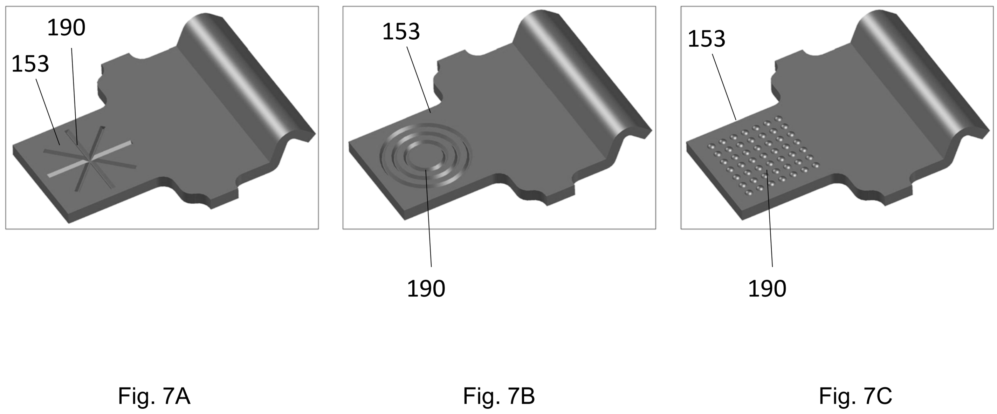

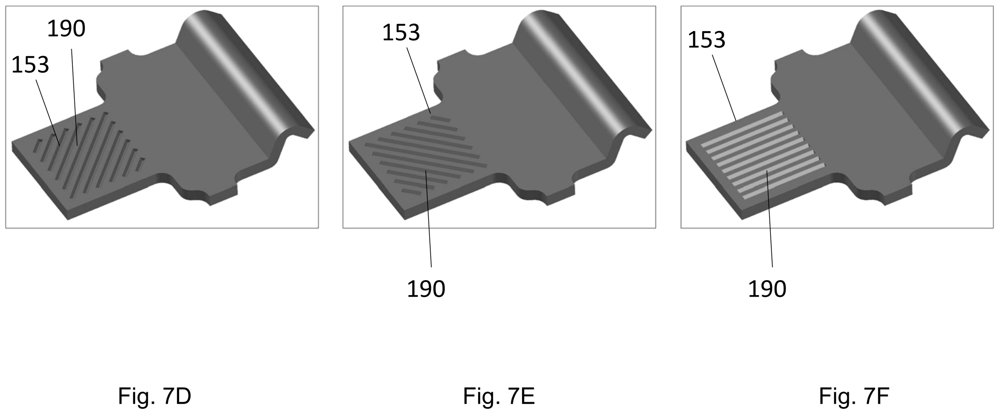

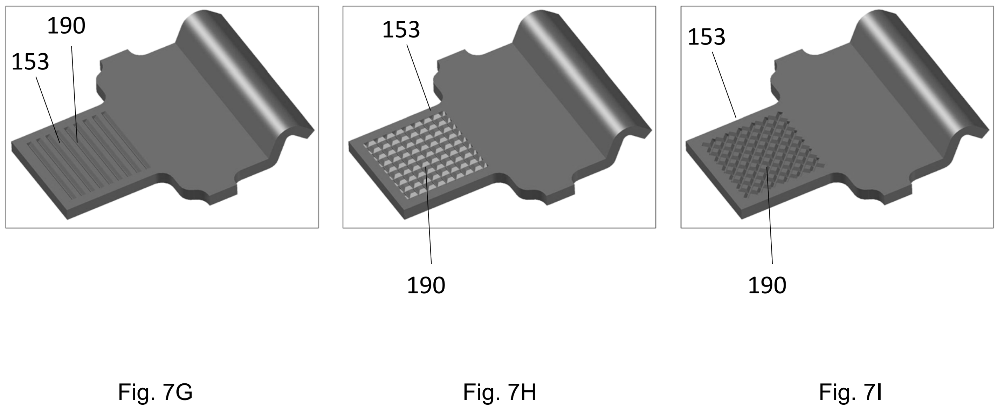

The cavity 190 at the die attachment portion side 153 of the bond clip 150 may have any other pattern. Figure 7 shows exemplary designs of the cavity 190, which are capable of providing expansion space between die attachment portion side 153 of the bond clip 150 and the die top solder 160, absorbing excessive solder volume.

Fig. 7A and Fig. 7B show the cavity 190 having a pattern as described with reference to Fig. 4 and Fig. 5, respectively.

Fig. 7C shows the cavity 190 having a form of circular blind holes arranged in rows, forming a 7x7 matrix of holes. However, in another variants, number of holes or their arrangement may be different, and the holes may have another crosssections and shapes, such as square, rectangular or triangular.

Fig. 7D, Fig. 7E, 7F and Fig. 7G show the cavity 190 formed as plurality of parallel grooves, in three exemplary arrangements. In Fig. 7D, the grooves are arranged obliquely to the edge of the clip attachment part 151 of the clip 150, at an angle of 45°, such that the adjacent grooves become smaller closer to the corner of the clip attachment part 151. In Fig. 7E, the grooves are arranged obliquely to the edge of the clip attachment part 151 of the clip 150, at an angle of 45°, oppositely to the arrangement shown in Fig. 7D. In Fig. 7F, the grooves are arranged parallelly to the side edges of the clip attachment part 151 of the clip 150, such that the grooves have equal length. In yet another variant, shown in Fig. 7G, the grooves are arranged parallelly to another side edge of the clip attachment part 151 of the clip 150, i.e. at a right angle to the arrangement of grooves shown in Fig. 7F. In yet another variant (not shown), the grooves may be arranged obliquely to the edge of the clip attachment part 151 at an angle other than 45° or may have different lengths, also when arranged parallelly to the side edges of the clip attachment part 151.

Fig. 7H and Fig. 7I show the cavity 190 formed as a plurality of grooves intersecting at right angles, thereby forming a grid of grooves, in two exemplary arrangements. The grid of grooves forms a matrix of protrusions (bumps) separated by grooves. As shown in Fig. 7H, the grid of grooves may be formed by a first set of grooves arranged parallelly to the side edges of the clip attachment part 151 and a second set of grooves arranged parallelly to another side edge (front edge) of the clip attachment part 151, while the first and second set of grooves intersect at an angle of 90o. In other words, the cavity shown in Fig. 7H is formed by combining the patterns shown in Fig. 7F and Fig. 7G. As shown in Fig. 7I, the grid of grooves may be formed by a first set of grooves arranged obliquely (at an angle of 45°) to the side edges of the clip attachment part 151 and a second set of grooves arranged obliquely to the side edges of the clip attachment part 151, at an angle of 90oC with respect to said first set of grooves. In other words, the cavity 190 shown in Fig. 7H is formed by combining the patterns shown in Fig. 7D and Fig. 7E. In yet another variants, the angle of intersection may be different than 90o, the angle at which the grooves are inclined with respect to the edges of the clip attachment part 151 may be different, or lengths of the grooves may vary.

With regard to the cavity 190 formed as at least one groove, the grooves may have various shapes in cross section. For example, the grooves may be V-shaped. V-shaped grooves allow to obtain matrix of upward protrusions having trapezoidal shape, as shown in Fig. 7H and 7I. In another variants, the grooves may be for example rectangular or U-shaped, or may have any other irregular shape in cross-section.

The exemplary patterns of the cavity 190 shown in Figs. 7A-7I, as explained above, are not limiting. Any other patterns and shapes or combinations of different patterns may be used, as long as they allow to provide a hollow expansion space between the die attachment portion side 153 of the conductive clip 150 and the die top solder 160.

The present disclosure herein is applicable to any bond clip semiconductor packages having solder joint as interconnection media between the semiconductor die and the conductive bond clip.

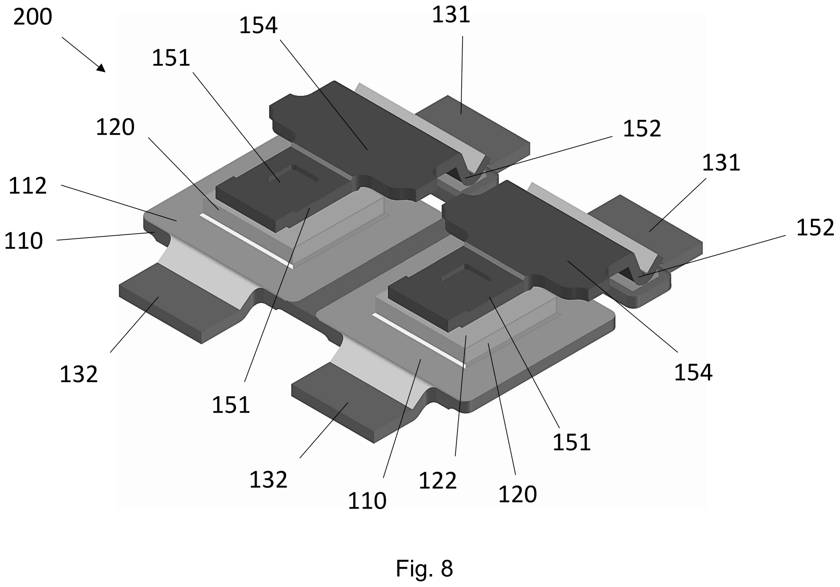

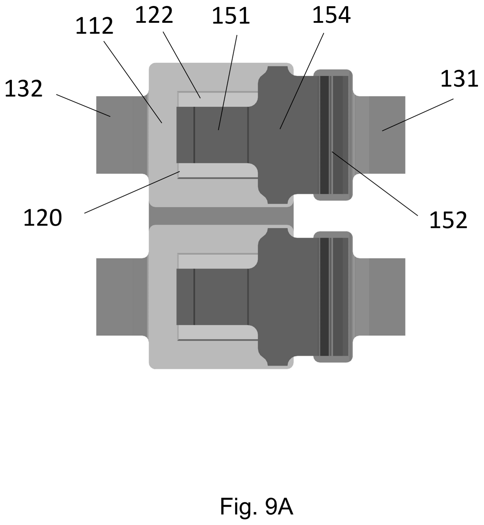

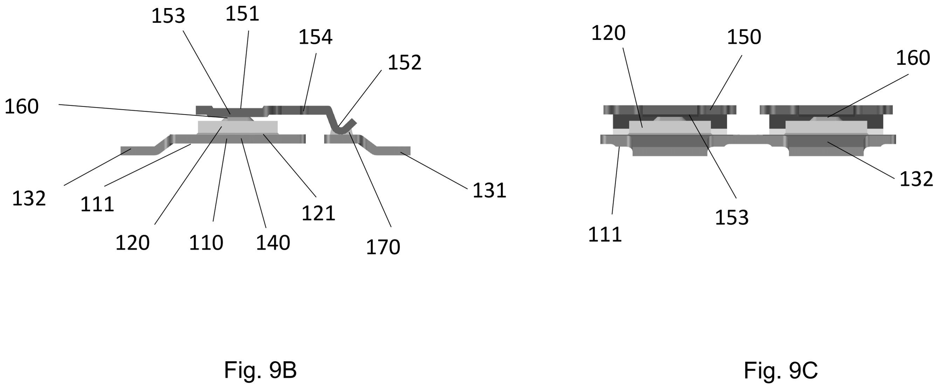

The disclosure is also applicable to semiconductor packaging utilizing more than one conductive clip 150, i.e. multiple clip package such as for example dual clip package. A dual clip semiconductor package 200 is shown in Figure 8 in perspective view. Figures 9A, 9B and 9C show the dual clip semiconductor package 200 in top view, side view and front view, respectively. The encapsulant 180 and optional tin plating 131 are not shown. Dual clip packages utilize two clips 150 to create multiple electrical connections within the same package. The components of the dual clip semiconductor package 200 are the same as described with reference to Figs. 1 to 7, whereby the components of the semiconductor package 200 are doubled, i.e. it comprises two sets of stacks of components, each including lead frame 110, semiconductor die 120, lead terminals 131,132, bond clip 150, solder joint connections, etc.

The semiconductor package 100 or multiple clip semiconductor package may comprise additional elements known to be used in such devices, such as for example heat sink and/or thermal pad.

If the solder joint is exposed to environmental factors like moisture or contamination, oxidation or corrosion can occur, degrading the joint's electrical and mechanical properties, leading to increased resistance and potential failure. Proper surface treatments or coatings may thus additionally be applied to prevent oxidation and maintain the performance of conductive clips over the device's lifecycle.

### LIST OF REFERENCE NUMERALS USED

- 100: semiconductor package
- 110: lead frame
- 111: first frame side
- 112: second frame side
- 120: semiconductor die
- 121: first die side
- 122: second die side
- 131: first lead terminal
- 132: second lead terminal
- 133: tin plating
- 140: die bottom solder
- 150: bond clip
- 151: die attachment portion of the bond clip
- 152: lead terminal attachment portion of the bond clip
- 153: die attachment portion side of the bond clip
- 154: bridge portion of the bond clip
- 160: die top solder
- 170: lead solder
- 180: encapsulant
- 190: cavity
- 191: solder non-wettable substance
- 200: dual clip semiconductor package

## Claims

1. A semiconductor package comprising:
a semiconductor die having a first die side and a second die side opposite to the first die side;
a lead frame having lead terminals, a first frame side and a second frame side opposite to the first frame side, wherein the semiconductor die is attached with its first die side to the second frame side of the lead frame;
at least one bond clip electrically and mechanically connecting the second die side of the semiconductor die to at least one of the lead terminals;
a die top solder connecting the bond clip and the semiconductor die, and
an electrically insulating encapsulant at least partly encapsulating the lead frame, the semiconductor die, the at least one bond clip and the lead terminals,
wherein the bond clip at least comprises a die attachment portion having a die attachment portion side structured to be connected to the second die side of the semiconductor die, and a lead terminal attachment portion structured to be connected to the lead terminal of the lead frame, and
wherein the die attachment portion side of the die attachment portion is provided with a cavity functioning as an expansion space for the die top solder.

2. The semiconductor package according to claim 1, wherein the cavity is separated from the die top solder by a solder non-wettable substance.

3. The semiconductor package according to claim 2, wherein the solder non-wettable substance is applied on the surface of the cavity.

4. The semiconductor package according to claim 2, wherein the solder non-wettable substance is applied on the surface of die top solder facing the die attachment portion side.

5. The semiconductor package according to claim 2 or 3 or 4, wherein the solder non-wettable substance is selected from a thin organic coating or parylene or silicone or Cu oxide layer or Al oxide layer.

6. The semiconductor package according to any one of the claims from 1 to 5, wherein the cavity has a volume corresponding to at least 6% of the overall volume of the die top solder.

7. The semiconductor package according to any one of the claims from 1 to 6, wherein the cavity occupies a surface area of 1% to 10% of the surface area of the die attachment portion side of the die attachment portion.

8. The semiconductor package according to any one of the claims from 1 to 7, wherein the bond clip comprises copper.

9. The semiconductor package according to any one of the claims from 1 to 8, wherein the cavity is formed as at least one groove.

10. The semiconductor package according to claim 9, wherein the cavity is formed as a plurality of parallel grooves.

11. The semiconductor package according to claim 9, wherein the cavity has a form of at least one circular groove, preferably multiple concentric circular grooves.

12. The semiconductor package according to any one of the claims from 1 to 8, wherein the cavity has a form of blind holes, preferably circular, square, rectangular or triangular holes.

13. The semiconductor package according to any one of the preceding claims, wherein the semiconductor package is a multiple clip semiconductor package.

14. A bond clip for use in a semiconductor package, formed of a shaped strip of electrically conductive material, the bond clip at least comprising:
a die attachment portion having a die attachment portion side structured to be connected to a semiconductor die of the semiconductor package, and
a lead terminal attachment portion structured to be connected to a lead terminal of a lead frame of the semiconductor package,
wherein the die attachment portion side of the die attachment portion is provided with a cavity functioning as an expansion space for a die top solder.

15. The bond clip according to claim 20, wherein a surface of the cavity is provided with a solder non-wettable substance.

16. The bond clip according to claim 20 or 21, wherein the solder non-wettable substance is selected from a thin organic coating or parylene or silicone or Cu oxide layer or Al oxide layer.

17. The bond clip according to any one of the claims from 20 to 23, wherein the cavity is formed as at least one groove.

18. The bond clip according to claim 24 or 25, wherein the grooves are arranged obliquely or parallelly to a side edge of the die attachment portion of the bond clip.

19. The bond clip according to claim 24, wherein the cavity has a form of intersecting grooves.

20. The bond clip according to claim 24, wherein the cavity has a form of at least one circular groove, preferably multiple concentric circular grooves.
